# EUROPÄISCHE PATENTSCHRIFT

(11) **EP 1 587 350 B1**
(45) Veröffentlichungstag und Bekanntmachung des Hinweises auf die Patenterteilung: **07.02.2007**
(21) Anmeldenummer: 04009144.9
(22) Anmeldetag: 16.04.2004
(51) Int. Cl.: H05K 3/32, H01L 23/538, H01R 4/02

(54) **Verfahren zur Kontaktierung eines elektrischen Bauelements auf einem flexiblen Schaltungsträger und flexibler Schaltungsträger mit einem darauf kontaktierten elektrischen Baulelement**
Method for metallizing an electric component on a flexible circuit support and flexible circuit support with an electric component metallized thereon
Procédé de métallisation d'un composant électrique sur un support flexible à circuit et support flexible à circuit avec un composant électrique métallisé sur ledit support

(43) Veröffentlichungstag der Anmeldung: 19.10.2005
(73) Patentinhaber: Delphi Technologies, Inc., Troy, MI 48007 (US)
(72) Erfinder: Kortwig, Carsten, 42929 Wermelskirchen (DE); Eder, Bernd, 42287 Wuppertal (DE); Berghaus, Harald, 42897 Remscheid (DE)
(74) Vertreter: Manitz, Finsterwald & Partner GbR

(56) Entgegenhaltungen:
- EP-A- 0 607 929
- US-B1- 6 683 377
- PATENT ABSTRACTS OF JAPAN Bd. 1998, Nr. 12, 31. Oktober 1998 (1998-10-31) -& JP 10 200217 A (IBIDEN CO LTD), 31. Juli 1998 (1998-07-31)
- PATENT ABSTRACTS OF JAPAN Bd. 0151, Nr. 14 (E-1047), 19. März 1991 (1991-03-19) & JP 3 006036 A (FUJIKURA LTD), 11. Januar 1991 (1991-01-11)

## Beschreibung

Die vorliegende Erfindung betrifft ein Verfahren zur Kontaktierung eines elektrischen Bauelements auf einem flexiblen Schaltungsträger, einen mit dem Verfahren herstellbaren flexiblen Schaltungsträger mit einem darauf kontaktierten elektrischen Bauelement und eine Vorrichtung zur Durchführung des Verfahrens.

Flexible Schaltungsträger sind grundsätzlich bekannt. Die zeichnen sich dadurch aus, dass auf oder in einem flexiblen Trägermaterial Leiterbahnen angeordnet sind, mittels derer elektrische Bauelemente, die auf dem jeweiligen Schaltungsträger gehalten sind, elektrisch untereinander oder mit Anschlusskontakten verbindbar sind. Als Trägermaterial können beispielsweise Kunststoffe bzw. Kunststofffolien Verwendung finden. Im Rahmen der vorliegenden Erfindung werden unter flexiblen Schaltungsträgern insbesondere so genannte FPCs ("Flexible Printed Circuits"), FFCs ("Flexible Flat Cables") und EFCs ("Extruded Flat Cables") verstanden.

Flexible Schaltungsträger zeichnen sie sich durch ein geringes Gewicht aus und können dank ihrer Flexibilität in ganz oder teilweise gekrümmter Anordnung sehr platzsparend eingesetzt werden.

Die Flexibilität der Schaltungsträger bringt jedoch auch Probleme mit sich. Zur Kontaktierung von Kontakten elektrischer Bauelemente mit einem flexiblen Schaltungsträger können beispielsweise Lötverbindungen eingesetzt werden. Bei deren Herstellung treten jedoch hohe Temperaturen auf, die gegebenenfalls den flexiblen Schaltungsträger beeinträchtigen können. Darüber hinaus sind die fertigen Lötverbindungen anfällig gegenüber Spannungen, die bei einer Verbiegung des flexiblen Schaltungsträgers auftreten können. Ab dem Jahr 2006 wird es in einigen Staaten notwendig sein, zum Löten bleifreies Lot zu verwenden. Es ist davon auszugehen, dass zur Herstellung von Lötverbindungen dann noch höhere Temperaturen erforderlich sind, die die Herstellung von Lötverbindungen ohne Beeinträchtigung des flexiblen Schaltungsträgers weiter erschweren könnten.

Aus der JP-A-03006036 ist bekannt, ein elektrisches Bauelement auf einem flexiblen Schaltungsträger anzubringen und anschließend den das Bauelement tragenden Bereich des Schaltungsträgers auszustanzen.

Die EP-A-0607929 beschreibt die elektrische Kontaktierung eines flexiblen Schaltungsträgers mittels einer Drahtbondverbindung, die durch Ultraschall-Bonden hergestellt und als Ball-Wedge-Verbindung ausgebildet ist.

Die US-B-6683377 offenbart ein Verfahren zur Kontaktierung wenigstens eines elektrischen Bauelements auf einem flexiblen Schaltungsträger, bei dem zwischen wenigstens einem Bauelementkontakt des Bauelements und wenigstens einer Kontaktfläche auf dem flexiblen Schaltungsträger eine Drahtbondverbindung hergestellt wird.

Aus der JP-A-10200217 ist ein Verfahren gemäß dem Oberbegriff des Anspruchs 1 bekannt.

Der vorliegenden Erfindung liegt die Aufgabe zugrunde, ein Verfahren zur Kontaktierung wenigstens eines elektrischen Bauelements auf einem flexiblen Schaltungsträger zu schaffen, das eine sichere und schonende Kontaktierung des elektrischen Bauelements mit dem flexiblen Schaltungsträger in einem kontinuierlichen Prozess erlaubt.

Zur Lösung der Aufgabe sind ein Verfahren mit den Merkmalen des Anspruchs 1 und eine Vorrichtung mit den Merkmalen des Anspruchs 10 vorgesehen.

Unter elektrischen Bauelementen werden im Rahmen der Erfindung allgemein Bauelemente verstanden, die zur Herstellung elektrischer und elektronischer Schaltungen verwendet werden können. Beispielsweise kann es sich hierbei um Kontaktelemente handeln, mittels derer Leiterbahnen des Schaltungsträgers mit komplementären Kontaktelementen eines Steckverbinders elektrisch verbindbar sind. Vorzugsweise wird die Erfindung jedoch für beliebige aktive und passive Bauelemente, insbesondere auch Bauelemente mit integrierten und/oder hochintegrierten elektronischen Schaltungen, verwendet.

Wie zuvor erwähnt, werden unter flexiblen Schaltungsträgern beliebige, wenigstens abschnittsweise leicht biegbare Schaltungsträger, vorzugsweise FFCs, FPCs, EFCs oder ähnliche Schaltungsträger, verstanden. Die Leiterbahnen in dem Schaltungsträger können entsprechend einer gewünschten elektrischen Verbindung des Bauelements mit einem anderen elektrischen Bauelement bzw. einem Kontaktelement vorgegeben sein.

Erfindungsgemäß werden zur Kontaktierung also Drahtbondverbindungen eingesetzt. Unter Drahtbondverbindungen werden dabei Verbindungen der Art verstanden, wie sie aus der Kontaktierung von elektrischen Bauelementen mit starren Leiterplatten dem Fachmann bekannt sind. Im Wesentlichen werden hierzu Bonddrähte ohne die Verwendung einer schmelzflüssigen Phase eines leitenden Materials, insbesondere von Lot, des Bonddrahts, der Kontaktfläche oder des Bauelementkontakts, mit entsprechenden metallischen Kontaktflächen verbunden. Die Technik des konventionellen Drahtbondens ist beispielsweise beschrieben in den Veröffentlichungen "DVS-Merkblätter und Richtlinien, Fügen in Elektronik und Feinwerktechnik, M2810 Drahtbonden (Ausgabe 09/1992)" sowie "DVS-Merkblätter und Richtlinien, Fügen in Elektronik und Feinwerktechnik, M2808 Mikrofügen (Ausgabe 06/1983)", jeweils DVS Verlag GmbH, Düsseldorf, Deutschland, deren Inhalt hiermit durch Bezugnahme in die Beschreibung aufgenommen wird.

Das erfindungsgemäße Verfahren weist den Vorteil auf, dass bei der Herstellung der Kontaktierung keine hohen Temperaturen auftreten, die eine Beschädigung des elektrischen Bauelements oder auch des flexiblen Schaltungsträgers mit sich bringen könnten.

In dem Fall, dass die Leiterbahnen des flexiblen Schaltungsträgers durch eine nur dünne Kunststoffschicht abgedeckt sind, ist es weiterhin nicht notwendig, die Kontaktfläche bereits vor Herstellung der Drahtbondverbindung in einem separaten Arbeitsschritt freizulegen. Vielmehr ist es möglich, diese Schicht bei dem Bondvorgang selbst zu beseitigen, indem das Ende des Bonddrahts entsprechend bewegt wird.

Darüber hinaus zeichnet sich ein erfindungsgemäß hergestellter flexibler Schaltungsträger mit einem darauf mittels einer Drahtbondverbindung kontaktierten Bauelement dadurch aus, dass die Drahtbondverbindung selbst eine gewisse Flexibilität aufweist und daher durch eine Verformung des flexiblen Schaltungsträgers nur eine Verformung der Bonddrähte hervorgerufen wird, die jedoch keine wesentlichen mechanischen Spannungen an den eigentlichen Kontaktierungsstellen zwischen den Enden des Bonddrahts und den Kontaktierungsflächen hervorruft.

Um eine möglichst hochautomatisierte Fertigung zu ermöglichen, ist es erfindungsgemäß vorgesehen, dass der zu verarbeitende flexible Schaltungsträger als Rolle aufgewickelt ist, dass zur Kontaktierung ein Abschnitt des flexiblen Schaltungsträgers von der Rolle abgewickelt wird, dass das Bauteil auf dem Abschnitt des flexiblen Schaltungsträgers angeordnet wird, dass der Bauelementkontakt und die Kontaktfläche auf dem flexiblen Schaltungsträger durch Drahtbonden elektrisch miteinander verbunden werden, und dass wenigstens ein Teil des Abschnitts des Schaltungsträgers wieder als Rolle aufgewickelt wird. Hierzu kann vorzugsweise eine erfindungsgemäße Vorrichtung mit den Merkmalen des Anspruchs 10 verwendet werden.

Die erfindungsgemäße Vorrichtung zur Kontaktierung wenigstens eines elektrischen Bauelements auf einem flexiblen Schaltungsträger umfasst eine Abwickeleinheit, mittels derer ein als Rolle aufgewickelter Schaltungsträger haltbar und abwickelbar ist, eine Positioniereinrichtung zur Positionierung des elektrischen Bauelements auf dem Schaltungsträger, eine Verbindungseinrichtung zur Herstellung einer Drahtbondverbindung zwischen wenigstens einem Bauelementkontakt des Bauelements und wenigstens einer Kontaktfläche auf dem flexiblen Schaltungsträger, und eine Aufwickeleinheit zum Aufwickeln wenigstens von Teilen des flexiblen Schaltungsträgers als Rolle.

Der flexible Schaltungsträger wird also in einem Rolle-zu-Rolle-Prozess verarbeitet, so dass aus einer ersten Rolle mit aufgewickeltem Schaltungsträger bzw. Schaltungsträgermaterial Teile einer elektrischen oder elektronischen Schaltung aus jeweils einem Abschnitt des flexiblen Schaltungsträgers und jeweils wenigstens einem darauf kontaktierten elektrischen Bauelement gefertigt werden können.

Zur Positionierung des elektrischen Bauelements auf dem flexiblen Schaltungsträger dient die Positioniereinrichtung, die vorzugsweise eine in wenigstens zwei, vorzugsweise drei voneinander unabhängigen Raumrichtungen bewegbare Halte- bzw. Greifeinrichtung zum Halten bzw. Greifen des elektrischen Bauelements und zum gezielten Absetzen an einer vorgegebenen Position auf dem flexiblen Schaltungsträger aufweist. Die Verbindungseinrichtung zur Herstellung der Drahtbondverbindung kann vorzugsweise ein entsprechendes, in wenigstens zwei voneinander unabhängigen Raumrichtungen bewegbares Bondwerkzeug zur Herstellung einer Drahtbondverbindung, besonders bevorzugt ein Ultraschallbond-Werkzeug bzw. einen Ultraschallbond-Kopf, aufweisen. Wenigstens eine der Raumrichtungen, in denen die Halte- bzw. Greifeinrichtung bzw. der Verbindungskopf bewegbar sind, ist vorzugsweise orthogonal zu der Fläche des flexiblen Schaltungsträgers in dem entsprechenden Arbeitsbereich ausgerichtet. Werden mehrere Bauelemente auf dem gleichen Schaltungsträger kontaktiert, so können die Positionierungs- und/oder die Verbindungseinrichtung mehrere gleichzeitig arbeitende Halte- bzw. Greifeinrichtungen bzw. Bondwerkzeuge zur Herstellung von Drahtbondverbindungen aufweisen.

Bei dem Rolle-zu-Rolle-Prozess ist es erfindungsgemäß vorgesehen, dass der Schaltungsträger kontinuierlich abgewickelt und ein Werkzeug zur Herstellung der Drahtbondverbindung bei Herstellung der Drahtbondverbindung mit dem Schaltungsträger mitbewegt wird. Die erfindungsgemäße Vorrichtung umfasst zu diesem Zweck eine Fördereinrichtung, mittels derer der Schaltungsträger kontinuierlich bewegbar ist. Ferner ist die Verbindungseinrichtung so ausgebildet, dass ein Werkzeug zur Herstellung der Drahtbondverbindung bei Herstellung der Drahtbondverbindung mit dem Schaltungsträger mitbewegbar ist. Auf diese Weise kann der Schaltungsträger kontinuierlich mit konstantem Zug und damit höchstens geringer Neigung zum Wellen abgewickelt bzw. am Ende des Prozesses wieder aufgewickelt werden.

Weiterbildungen und bevorzugte Ausführungsformen der Erfindung sind in den Ansprüchen, der Beschreibung und den Zeichnungen beschrieben.

Grundsätzlich kann zur Herstellung der Drahtbondverbindung jedes zur Herstellung von Drahtbondverbindungen geeignete Verfahren verwendet werden._ Beispielsweise kann Thermokompressionsbonden angewendet werden. Um die Zuführung von Wärme möglichst gering zu halten, ist es jedoch bevorzugt, dass zur Herstellung der Drahtverbondverbindung Ultraschall-Bonden verwendet wird. Dabei kann gegebenenfalls zusätzlich Wärme zugeführt werden (sog. "Thermosonic Bonding").

Bei der Führung des Bonddrahts können grundsätzlich beliebige bekannte Bonddrahtführungen, beispielsweise wie bei dem sogenannten "Wedge-Wegde-Bonden", verwendet werden. Es ist jedoch bevorzugt, dass eine Ball-Wedge-Drahtbondverbindung hergestellt wird. Eine solche Verbindung zeichnet sich durch eine größere Stabilität bei einer Biegung des Schaltungsträgers unterhalb des entsprechenden Bonddrahts aus.

Um eine möglichst präzise Positionierung des elektrischen Bauelements auf dem flexiblen Schaltungsträger und damit eine präzise Herstellung der Drahtbondverbindung zu erleichtern, ist es bevorzugt, dass der Abschnitt des flexiblen Schaltungsträgers zur Anordnung des Bauelements auf demselben und/oder zur Herstellung der Drahtbondverbindung durch Unterdruck auf eine Arbeitsfläche gezogen wird. Bei der erfindungsgemäßen Vorrichtung ist es hierzu bevorzugt, dass wenigstens ein Vakuumtisch vorgesehen ist, auf den der Schaltungsträger bei der Positionierung des Bauelements und/oder der Herstellung der Drahtbondverbindung durch Unterdruck ziehbar ist. Dabei genügt es, dass der Abschnitt des Schaltungsträgers nur im Bereich des Bauelements auf die Arbeitsfläche bzw. den Vakuumtisch gezogen wird, vorzugsweise geschieht dies jedoch über die gesamte Breite des Schaltungsträgers. Vorzugsweise liegt der Abschnitt des Schaltungsträgers in dem Bereich im Wesentlichen vollflächig an der Arbeitsfläche bzw. dem Vakuumtisch an. Die Arbeitsfläche bzw. die Oberfläche des Vakuumtischs kann grundsätzlich eine beliebige, zur Herstellung von Drahtbondverbindungen geeignete Form aufweisen. Um Bauelemente nahe zueinander anordnen und doch Drahtbondverbindungen automatisch herstellen zu können, kann die Fläche beispielsweise konvex nach außen gewölbt sein, so dass die Bauelemente bei der Kontaktierung radial nach außen abstehen und ein Bondwerkzeug leichter zwischen diese geführt werden kann. Vorzugsweise ist sie jedoch plan bzw. eben. Durch diese Weiterbildung kann eine unerwünschte Verbiegung oder Wellung des Schaltungsträgermaterials, das beispielsweise durch die Bereitstellung des Materials als Rolle bedingt sein kann, wenigstens für die Dauer der Positionierung des elektrischen Bauelements und/oder der Herstellung der Drahtbondverbindung beseitigt werden.

Durch Kontaktierung von elektrischen Bauelementen mit Abschnitten des flexiblen Schaltungsträgers können wenigstens Teile elektrischer oder elektronischer Schaltungen hergestellt werden. Bei einer Ausführungsform des erfindungsgemäßen Verfahrens ist es daher bevorzugt, dass der Abschnitt des flexiblen Schaltungsträgers mit dem Bauelement als Rolle aufgewickelt wird. Es entsteht so wiederum eine Rolle, auf der auf einem flexiblen Schaltungsträger mehrere elektrische bzw. elektronische Schaltungen gebildet sind, die zwar elektrisch voneinander unabhängig, aber zur weiteren Verarbeitung noch mechanisch miteinander verbunden sind. Dies kann bei der Weiterverarbeitung der hergestellten elektrischen bzw. elektronischen Schaltungen von Vorteil sein, da diese nicht einzeln gehandhabt zu werden brauchen.

Bei einer anderen Ausführungsform des erfindungsgemäßen Verfahrens ist es bevorzugt, dass ein Bereich des Abschnitts des flexiblen Schaltungsträgers mit dem elektrischen Bauelement ausgestanzt wird, und dass der nicht ausgestanzte Bereich des Abschnitts des flexiblen Schaltungsträgers als Rolle aufgewickelt wird. Bei der erfindungsgemäßen Vorrichtung ist es hierzu bevorzugt, dass vor der Aufwickeleinheit eine Stanzeinrichtung vorgesehen ist, um einen Bereich eines Abschnitts des flexiblen Schaltungsträgers mit dem Bauelement auszustanzen. Auf diese Weise können sehr einfach einzelne elektrische bzw. elektronische Schaltungen auf flexiblen Schaltungsträgern hergestellt werden. Dadurch, dass die Schaltungen durch Ausstanzen erhalten werden, kann mittels der verbleibenden Teile des Schaltungsträgers durch das Aufwickeln immer noch ein Zug auf den aufgewickelten Teil des Schaltungsträgers ausgeübt werden, mittels dessen dieser abwickelbar ist.

Um die hergestellte Kontaktierung vor äußeren Einflüssen wie beispielsweise Feuchtigkeit zu schützen, ist es bevorzugt, dass wenigstens der Bauelementkontakt, der Bonddraht und die Kontaktfläche nach Herstellung der Bondverbindung und vor dem Aufwickeln versiegelt werden. Bei der erfindungsgemäßen Vorrichtung ist es dazu bevorzugt, dass eine Versiegelungseinrichtung in Transportrichtung des flexiblen Schaltungsträgers nach der Verbindungseinrichtung angeordnet ist, mittels derer wenigstens der Bauelementkontakt, der Bonddraht und die Kontaktfläche nach Herstellung der Bondverbindung und vor dem Aufwickeln versiegelbar sind. Die Versiegelung kann mit an sich bekannten Stoffen und Verfahren vorgenommen werden. Beispielsweise können Lacke oder Gele verwendet werden, die elektrisch isolierend sind und vorzugsweise auch eine hinreichende mechanische Festigkeit aufweisen. Die Versiegelung kann sich auch die gesamte Fläche der hergestellten Schaltung erstrecken.

Um eine möglichst große Anzahl voneinander getrennter elektrischer bzw. elektronischer Schaltungen möglichst in kurzer Zeit herstellen zu können, ist es bevorzugt, dass parallel für mehrere elektrisch voneinander getrennte Schaltungen Bauelemente auf dem Schaltungsträger kontaktiert werden. Es können damit parallel nebeneinander auf dem gleichen Schaltungsträger mehrere Schaltungen gleichzeitig mit Bauelementen bestückt und kontaktiert werden, wozu der flexible Schaltungsträger nur entsprechende Leiterbahnenmuster aufzuweisen braucht. Die Positionierungs- und Verbindungseinrichtung können hierzu eine entsprechende Anzahl von parallel arbeitenden Greif- oder Halteeinrichtungen bzw. Bondwerkzeugen aufweisen.

Die Erfindung wird im Folgenden noch weiter beispielhaft anhand der Zeichnungen erläutert. Es zeigen:
- Fig. 1: eine schematische Darstellung einer Vorrichtung zur Kontaktierung wenigstens eines elektrischen Bauelements auf einem flexiblen Schaltungsträger nach einer ersten bevorzugten Ausführungsform der Erfindung,
- Fig. 2: eine schematische Darstellung eines elektrischen Bauelements auf einem Abschnitt eines flexiblen Schaltungsträgers, das auf diesem mittels Drahtbondverbindungen kontaktiert ist, und
- Fig. 3: eine Vorrichtung zur Kontaktierung wenigstens eines elektrischen Bauelements auf einem flexiblen Schaltungsträger nach einer zweiten bevorzugten Ausführungsform der Erfindung.

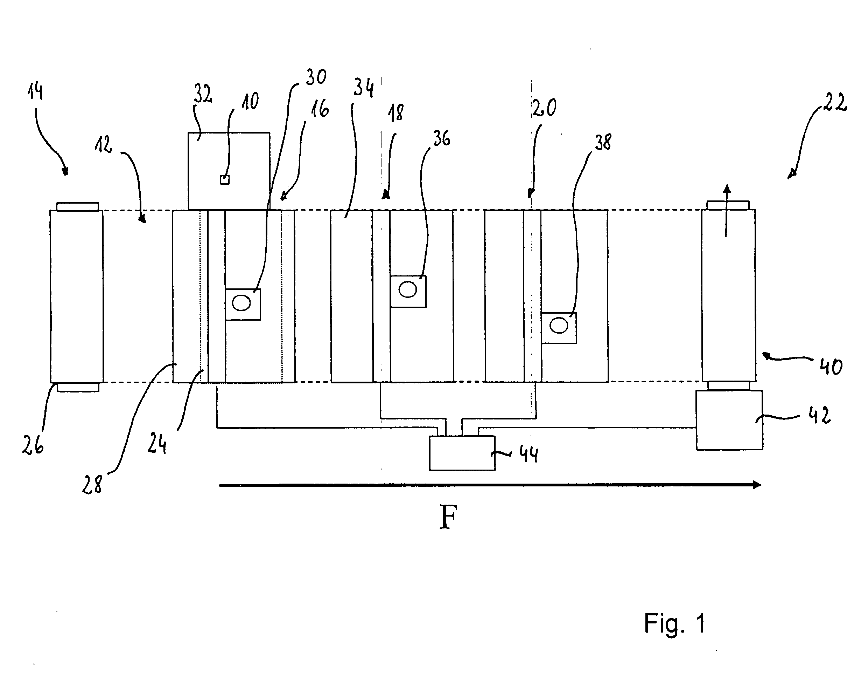

In Fig. 1 umfasst eine Vorrichtung zur Kontaktierung wenigstens eines elektrischen Bauelements 10 auf einem flexiblen Schaltungsträger 12 nach einer ersten bevorzugten Ausführungsform der Erfindung entlang einer Förderrichtung F, entlang derer der Schaltungsträger 12 bewegt wird, eine Abwickeleinheit 14, mittels derer ein als Rolle aufgewickelter Schaltungsträger 12 haltbar und abwickelbar ist, eine Positioniereinrichtung 16 zur Positionierung des elektrischen Bauelements 10 auf dem Schaltungsträger 12, eine Verbindungseinrichtung 18 zur Herstellung einer Drahtbondverbindung zwischen wenigstens einem Bauelementkontakt des Bauelements 10 und wenigstens einer Kontaktfläche auf dem flexiblen Schaltungsträger 12, eine Versiegelungseinrichtung 20 zur Versiegelung der hergestellten Kontaktierung und eine Aufwickeleinheit 22 zum Aufwickeln wenigstens von Teilen des flexiblen Schaltungsträgers 12.

Bei dem flexiblen Schaltungsträger 12 kann es sich um ein FFC, FPC oder ein EFC handeln, der als langgestrecktes Band aufgewickelt ist. Die Leiterbahnen darin sind entsprechend einer vorgegebenen, herzustellenden elektronischen Schaltung ausgebildet, so dass aus dem einen flexiblen Schaltungsträger 12 bzw. Band nacheinander mehrere elektrische bzw. elektronische Schaltungen, die elektrisch voneinander getrennt sind, herstellbar sind. Für je eine Schaltung ist dabei je ein Abschnitt 24 des Schaltungsträgers 12 vorgesehen, der in Fig. 1 durch gepunktete Linien angedeutet ist.

Im Beispiel ist das elektrische Bauelement 10 ein Chip mit einer integrierten Schaltung bzw. ein ASIC.

Der flexible Schaltungsträger 12 ist auf der Abwickeleinheit 14 gehalten, die eine entsprechende drehbar gelagerte erste Spule 26 aufweist, auf der der Schaltungsträger 12 als Rolle aufgewickelt ist. Die erste Spule 26 ist zur Bereitstellung neuen Schaltungsträgermaterials auswechselbar.

Von der Abwickeleinheit 14 abgewickelter flexibler Schaltungsträger 12 wird der Positioniereinrichtung 16 zugeführt, die auf einem Abschnitt 24 des Schaltungsträgers 12 das elektrische Bauelement 10 an einer vorgegebenen Position positioniert. Die Positioniereinrichtung 16 verfügt dazu über einen Vakuumtisch 28, der in der planen Tischfläche Ansaugöffnungen aufweist, die mit einer in Fig. 1 nicht gezeigten Pumpe verbunden sind, mittels derer ein Unterdruck erzeugbar ist. Die Breite des Vakuumtischs 28 entspricht dabei der Breite des Schaltungsträgers 12, so dass dieser über seine gesamte Breite an die Fläche des Vakuumtisches ansaugbar bzw. ziehbar ist und dann im Wesentlichen vollflächig auf diesem auf- bzw. an diesem anliegt. Weiterhin entspricht die Länge des Vakuumstischs 28 der Länge des Abschnitts 24 des Schaltungsträgers 12, so dass eine Schaltung bzw. ein Schaltungsteil in einem Arbeitsgang herstellbar ist.

Über dem Vakuumtisch 24 ist als Greifeinrichtung ein Greifer 30 vorgesehen, der in Richtungen parallel zur Förderrichtung F des Schaltungsträgers 12, senkrecht zur Ebene des Schaltungsträgers 12 und auch senkrecht zur Förderrichtung F des Schaltungsträgers 12 unabhängig verfahrbar ist und mittels dessen elektrische Bauelemente 10 aus einem Bauelementvorrat 32 entnehmbar, auf eine entsprechende Position relativ zu dem Schaltungsträger 12 transportierbar und dort absetzbar sind.

In Förderrichtung F folgt die Verbindungseinrichtung 18, die ebenfalls über einen Vakuumtisch 34 verfügt, der wie der Vakuumtisch 28 ausgebildet ist. Die Verbindungseinrichtung 18 besitzt weiterhin als Bondwerkzeug einen in den gleichen Raumrichtungen wie der Greifer 30 unabhängig verfahrbaren Ultraschall-Bond-Kopf 36, mittels dessen eine Drahtbondverbindung zwischen einem Bauelementkontakt und einer vorgegebenen Kontaktfläche auf dem flexiblen Schaltungsträger 12 durch Ultraschall Bonden herstellbar ist.

In Förderrichtung F hinter der Verbindungseinrichtung 18 ist die Versiegelungseinrichtung 20 angeordnet, die über einen in den gleichen Raumrichtungen wie der Greifer 30 und der Ultraschall-Bond-Kopf 36 verfahrbaren Versiegelungskopf 38 verfügt, durch den ein Versiegelungslack auf eine vorgegebene Position auf dem Schaltungsträger 12 und insbesondere eine hergestellte Kontaktierung abgebbar ist.

Die Aufwickeleinheit 22 besitzt eine drehbar gelagerte zweite Spule 40, die mittels eines Antriebs 42 drehbar ist. Die zweite Spule 40 dient dazu, den Schaltungsträger 12 in Förderrichtung F zu ziehen und entsprechend der Fördergeschwindigkeit bzw. der Förderbewegung als Rolle aufzuwickeln. Auch sie ist zur Entnahme des als Rolle aufgewickelten Schaltungsträgers 12 austauschbar.

Die Positioniereinrichtung 16, die Verbindungseinrichtung 18, die Versiegelungseinrichtung 20 und die Aufwickeleinheit 22 werden über eine Steuereinrichtung 44 so gesteuert, dass die Bewegung des Schaltungsträgers 12 relativ zu der Positioniereinrichtung 16, der Verbindungseinrichtung 18 und der Versiegelungseinrichtung 20 zeitlich abgestimmt mit der Bewegung des Greifers 30 bzw. des Ultraschall-Bond-Kopf 36 und des Versiegelungskopfs 32 erfolgt. Weiterhin steuert die Steuereinrichtung 52, zu welchen Zeiten an den Vakuumtischen 28 und 34 ein Unterdruck angelegt wird.

Die Herstellung einer elektronischen Schaltung bzw. die Kontaktierung des elektrischen Bauelements 10 auf dem flexiblen Schaltungsträger 12 erfolgt mit folgendem Verfahren nach einer ersten bevorzugten Ausführungsform der Erfindung.

Der flexible Schaltungsträger 12 wird durch Drehung der zweiten Spule 40 mit dem Antrieb 42 von der Abwickeleinheit 14 bzw. der ersten Spule 26 abgewickelt und über die folgenden Einrichtungen, d.h. die Positioniereinrichtung 16, die Verbindungseinrichtung 18 und die Versiegelungseinrichtung 20 gezogen. Die Bewegung erfolgt dabei abschnittsweise, so dass ein Abschnitt 24 des flexiblen Schaltungsträgers 12, der einer elektronischen Schaltung entspricht, jeweils für die zur Bearbeitung notwendige Zeit in der Positioniereinrichtung 16, der Verbindungseinrichtung 18 und der Versiegelungseinrichtung 20 ruht, bevor er zur nächsten Bearbeitungsstation bewegt wird.

Während dieser Ruhezeiten wird der Schaltungsträger 12 durch entsprechenden Unterdruck auf die Vakuumtische 28 bzw. 34 gesaugt bzw. gezogen und liegt in einer vorgegebenen Position auf diesen plan und im Wesentlichen vollflächig auf. Zur seitlichen Führung des Schaltungsträgers 12 können entsprechende Führungselemente vorgesehen sein.

Es wird also zunächst ein Abschnitt 24 des Schaltungsträgers 12 in den Bereich der Positioniereinrichtung 14 bewegt, wo der Greifer 30 gesteuert durch die Steuereinrichtung 44 wenigstens ein elektrisches Bauelement 10 aus dem Bauelementvorrat 46 entnimmt und auf eine vorgegebene Position auf dem Abschnitt 24 des flexiblen Schaltungsträgers 12 anordnet bzw. positioniert. Vorzugsweise kann dabei die Unterseite des elektrischen Bauelements 10 zuvor mit einem Kleber behandelt worden sein, so dass dieses auf dem flexiblen Schaltungsträger 12 haftet.

Nachdem das Bauelement 10 und gegebenenfalls alle weiteren für die Schaltung vorgesehenen Bauelemente auf dem Abschnitt 24 des Schaltungsträgers 12 positioniert wurden, wird der Abschnitt 24 des flexiblen Schaltungsträgers 12 mit dem darauf aufgeklebten elektrischem Bauelement 10 und gegebenenfalls weiteren Bauelementen in die Verbindungseinrichtung 18 bewegt und dort auf dem Vakuumtisch 34 angesaugt.

Der Ultraschall-Bond-Kopf 36 wird gesteuert durch die Steuereinrichtung 44 in den Bereich über einem Bauelementkontakt des Bauelements 10 und einer Kontaktfläche des flexiblen Schaltungsträgers 12 geführt und es wird, beispielsweise unter Verwendung eines Gold-Bonddrahts, mittels des Ultraschall-Bond-Kopfes 36 eine Ball-Wedge-Drahtbondverbindung durch Ultraschall-Bonden hergestellt. Dabei wird die Kontaktfläche auf dem Schaltungsträger 12 erst durch die Bewegung des Bonddrahts bei der Herstellung der Drahtbondverbindung freigelegt. Gegebenenfalls werden in entsprechender Weise weitere Drahtbondverbindungen hergestellt, wozu der Ultraschall-Bond-Kopf 36 mehrmals verfahren und die entsprechende Verbindungen hergestellt werden können.

Nachdem alle Drahtbondverbindungen hergestellt wurden, wird der Abschnitt 24 des Schaltungsträgers 12 in die Versiegelungseinrichtung 18 bewegt, wo gesteuert durch die Steuereinrichtung 44 durch Verfahren des Versiegelungskopfs 32 die hergestellten Drahtbondverbindungen durch Besprühen mit einem entsprechenden Schutzlack versiegelt werden.

Nach Trocknen des Schutzlacks wird der Abschnitt 24 des Schaltungsträgers 12 mit der so gebildeten elektronischen Schaltung von der Aufwickeleinheit 22 mittels des Antriebs 42 auf die zweite Spule 40 als Rolle aufgewickelt.

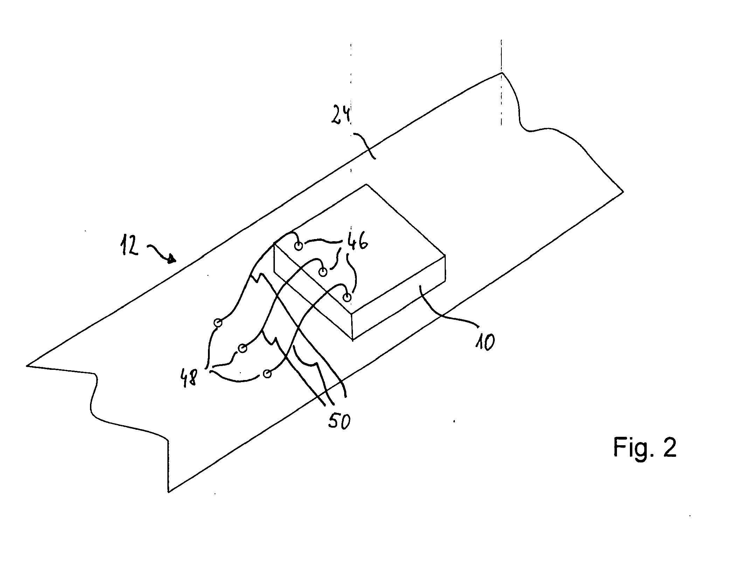

Wie in Fig. 2 gezeigt, entsteht so auf einfache Weise eine Drahtbondverbindung zwischen einem Bauelementkontakt 46 des elektrischen Bauelements 10 und einer Kontaktfläche 48 auf dem flexiblen Schaltungsträger 12 mittels eines Bonddrahts 50.

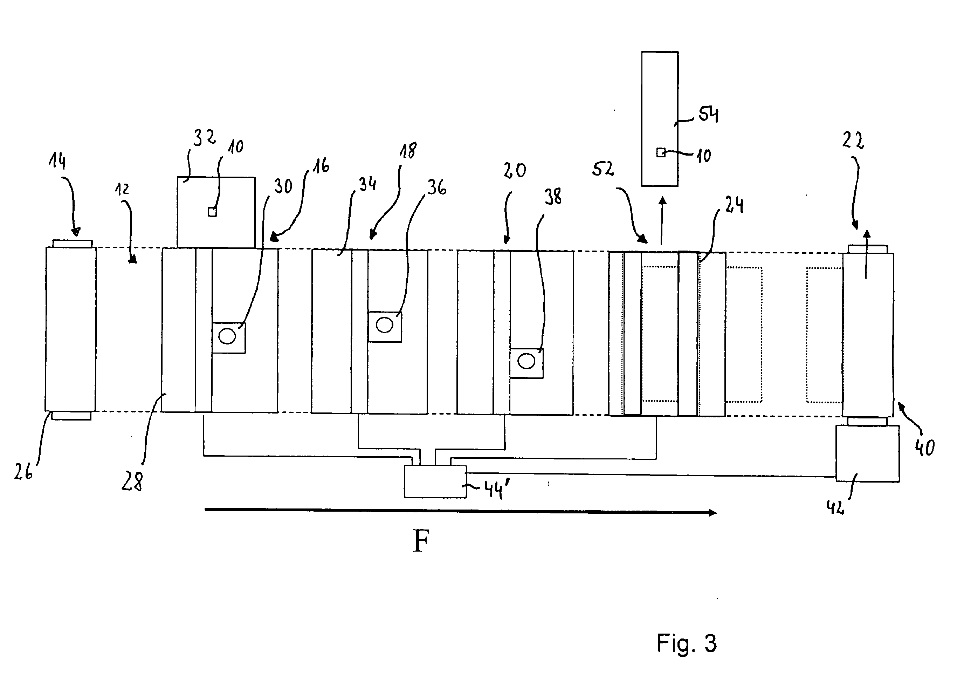

Ein zweites Ausführungsbeispiel unterscheidet sich von dem ersten Ausführungsbeispiel dadurch, dass die hergestellten elektronischen Schaltungen nicht auf eine Rolle aufgewickelt, sondern ausgestanzt werden. Eine entsprechende Vorrichtung nach einer zweiten bevorzugten Ausführungsform der Erfindung ist in Fig. 3 schematisch dargestellt und unterscheidet sich von der Vorrichtung des ersten Ausführungsbeispiels nur durch die Stanzeinrichtung 52 und eine modifizierte Steuereinrichtung 44', so dass für die anderen, gleichen Einrichtungen die gleichen Bezugszeichen wie im ersten Ausführungsbeispiel verwendet werden.

Die mit der Steuereinrichtung 44' verbundene und durch diese gesteuerte Stanzeinrichtung 52 ist zwischen der Versiegelungseinrichtung 20 und der Aufwickeleinheit 22 angeordnet. Mittels der Stanzeinrichtung 52 ist ein einer elektronischen Schaltung entsprechender Bereich 54 aus einem Abschnitt 24 des Schaltungsträgers 12 mit wenigstens einem elektrischen Bauelement ausstanzbar und seitlich in Bezug auf die Förderrichtung F entnehmbar.

Die Steuereinrichtung 44' ist gegenüber der Steuereinrichtung 44 des ersten Ausführungsbeispiels dahingehend modifiziert, dass sie auch die Funktion der Stanzeinrichtung 52 in Abstimmung mit der der Positioniereinrichtung 16, der Verbindungseinrichtung 18, der Versiegelungseinrichtung 20 und der Aufwickeleinheit 22 steuert.

Das Kontaktierungsverfahren nach einer zweiten bevorzugten Ausführungsform der Erfindung unterscheidet sich von dem im ersten Ausführungsbeispiel geschilderten Verfahren dadurch, dass nach der Versiegelung der hergestellten Kontaktierungen der Abschnitt 24 des Schaltungsträgers in den Bereich der Stanzeinrichtung 54 bewegt wird, wo ein Bereich 54 mit der gebildeten elektronischen Schaltung ausgestanzt und zur Seite weg bewegt wird. Der verbleibende Teil des Schaltungsträgers wird dann auf die Aufwickeleinheit 22 aufgewickelt, wodurch gleichzeitig der noch nicht aufgewickelte Teil des Schaltungsträgers 12 in Förderrichtung F bewegt bzw. von der ersten Spule 26 abgewickelt wird.

### Bezugszeichenliste

- 10: elektrisches Bauelement
- 12: flexibler Schaltungsträger
- 14: Abwickeleinheit
- 16: Positioniereinrichtung
- 18: Verbindungseinrichtung
- 20: Versiegelungseinrichtung
- 22: Aufwickeleinheit
- 24: Abschnitt
- 26: erste Spule
- 28: Vakuumtisch
- 30: Greifer
- 32: Bauelementvorrat
- 34: Vakuumtisch
- 36: Ultraschall-Bond-Kopf
- 38: Versiegelungskopf
- 40: zweite Spule
- 42: Antrieb
- 44: Steuereinrichtung
- 46: Bauelementkontakt
- 48: Kontaktfläche
- 50: Bonddraht
- 52: Stanzeinrichtung
- 54: Bereich

## Patentansprüche

1. Verfahren zur Kontaktierung wenigstens eines elektrischen Bauelements (10) auf einem flexiblen Schaltungsträger (12), bei dem der zu verarbeitende flexible Schaltungsträger (12) als Rolle aufgewickelt ist,
zur Kontaktierung ein Abschnitt (24) des flexiblen Schaltungsträgers (12) von der Rolle abgewickelt wird,
das Bauelement (10) auf dem Abschnitt (24) des flexiblen Schaltungsträgers (12) angeordnet wird,
zwischen wenigstens einem Bauelementkontakt (46) des Bauelements (10) und wenigstens einer Kontaktfläche (48) auf dem flexiblen Schaltungsträger (12) eine Drahtbondverbindung hergestellt wird, und
wenigstens ein Teil des Abschnitts (24) des Schaltungsträgers (12) wieder als Rolle aufgewickelt wird,
**dadurch gekennzeichnet,**
**dass** der Schaltungsträger (12) kontinuierlich abgewickelt und ein Werkzeug (36) zur Herstellung der Drahtbondverbindung bei Herstellung der Drahtbondverbindung mit dem Schaltungsträger (12) mitbewegt wird.

2. Verfahren nach Anspruch 1,
**dadurch gekennzeichnet,**
**dass** zur Herstellung der Drahtbondverbindung Ultraschall-Bonden verwendet wird.

3. Verfahren nach Anspruch 1 oder 2,
**dadurch gekennzeichnet,**
**dass** eine Ball-Wedge-Drahtbondverbindung hergestellt wird.

4. Verfahren nach einem der vorherigen Ansprüche,
**dadurch gekennzeichnet,**
**dass** der Abschnitt (24) des flexiblen Schaltungsträgers (12) zur Anordnung des Bauelements (10) auf demselben und/oder zur Herstellung der Drahtbondverbindung durch Unterdruck auf eine Arbeitsfläche (28, 34) gezogen wird.

5. Verfahren nach einem der vorherigen Ansprüche,
**dadurch gekennzeichnet,**
**dass** der Abschnitt (24) des flexiblen Schaltungsträgers (12) mit dem Bauelement (10) als Rolle aufgewickelt wird.

6. Verfahren nach einem der Ansprüche 1 bis 4,
**dadurch gekennzeichnet,**
**dass** ein Bereich (54) des Abschnitts (24) des flexiblen Schaltungsträgers (12) mit dem elektrischen Bauelement (10) ausgestanzt wird, und
**dass** der nicht ausgestanzte Bereich des Abschnitts (24) des flexiblen Schaltungsträgers (12) als Rolle aufgewickelt wird.

7. Verfahren nach einem der vorherigen Ansprüche,
**dadurch gekennzeichnet,**
**dass** wenigstens der Bauelementkontakt (46), der Bonddraht (50) und die Kontaktfläche (48) nach Herstellung der Bondverbindung und vor dem Aufwickeln versiegelt werden.

8. Verfahren nach einem der vorherigen Ansprüche,
**dadurch gekennzeichnet,**
**dass** parallel für mehrere elektrisch voneinander getrennte Schaltungen (54) Bauelemente (10) auf dem Schaltungsträger (12) kontaktiert werden.

9. Vorrichtung zur Kontaktierung wenigstens eines elektrischen Bauelements (10) auf einem flexiblen Schaltungsträger (12),
mit einer Abwickeleinheit (14), mittels derer ein als Rolle aufgewickelter Schaltungsträger (12) haltbar und abwickelbar ist,
einer Positioniereinrichtung (16) zur Positionierung des elektrischen Bauelements (10) auf dem Schaltungsträger (12),
einer Verbindungseinrichtung (18) zur Herstellung einer Drahtbondverbindung zwischen wenigstens einem Bauelementkontakt (46) des Bauelements (10) und wenigstens einer Kontaktfläche (48) auf dem flexiblen Schaltungsträger (12),
einer Aufwickeleinheit (22) zum Aufwickeln wenigstens von Teilen des flexiblen Schaltungsträgers (12) als Rolle, und
einer Fördereinrichtung (42), mittels derer der Schaltungsträger (12) kontinuierlich bewegbar ist,
**dadurch gekennzeichnet,**
**dass** die Verbindungseinrichtung (18) so ausgebildet ist, dass ein Werkzeug (36) zur Herstellung der Drahtbondverbindung bei Herstellung der Drahtbondverbindung mit dem Schaltungsträger (12) mitbewegbar ist.

10. Vorrichtung nach Anspruch 9,
**dadurch gekennzeichnet**,
wenigstens ein Vakuumtisch (28, 34) vorgesehen ist, auf den der Schaltungsträger (12) bei der Positionierung des Bauelements (10) und/oder der Herstellung der Drahtbondverbindung durch Unterdruck ziehbar ist.

11. Vorrichtung nach Anspruch 9 oder 10,
**dadurch gekennzeichnet,**
**dass** vor der Aufwickeleinheit (22) eine Stanzeinrichtung (52) vorgesehen ist, um einen Bereich (54) eines Abschnitts (24) des flexiblen Schaltungsträgers (12) mit dem Bauelement (10) auszustanzen.

12. Vorrichtung nach einem der Ansprüche 9 bis 11,
**dadurch gekennzeichnet,**
**dass** eine Versiegelungseinrichtung (20) in Transportrichtung des flexiblen Schaltungsträgers (12) nach der Verbindungseinrichtung (18) angeordnet ist, mittels derer wenigstens der Bauelementkontakt (46), der Bonddraht (50) und die Kontaktfläche (48) nach Herstellung der Bondverbindung und vor dem Aufwickeln versiegelbar sind.

## Claims

1. A method of contacting at least one electrical component (10) on a flexible circuit substrate (12), wherein
the flexible circuit substrate (12) to be processed is wound up as a roll;
a section (24) of the flexible circuit substrate (12) is unwound from the roll for the contacting;
the component (10) is arranged on the section (24) of the flexible circuit substrate (12);
a wire bond connection is established between at least one component contact (46) of the component (10) and at least one contact area (48) on the flexible circuit substrate (12); and
at least a part of the section (24) of the circuit substrate (12) is again wound up as a roll,
**characterized in that**
the circuit substrate (12) is unwound continuously and a tool (36) for the establishing of the wire bond connection is moved along with the circuit substrate (12) on the establishing of the wire bond connection.

2. A method in accordance with claim 1, **characterized in that** ultrasonic bonding is used to establish the wire bond connection.

3. A method in accordance with claim 1 or claim 2, **characterized in that** a ball-wedge wire bond connection is established.

4. A method in accordance with any one of the preceding claims, **characterized in that** the section (24) of the flexible circuit substrate (12) is pulled onto a work surface (28, 34) by underpressure for the arrangement of the component (10) on said section and/or for the establishing of the wire bond connection.

5. A method in accordance with any one of the preceding claims, **characterized in that** the section (24) of the flexible circuit substrate (12) with the component (10) is rolled up as a roll.

6. A method in accordance with any one of the claims 1 to 4, **characterized in that** a region (54) of the section (24) of the flexible circuit substrate (12) is stamped out with the electrical component (10); and
**in that** the region of the section (24) of the flexible circuit substrate (12) not stamped out is wound up as a roll.

7. A method in accordance with any one of the preceding claims, **characterized in that** at least the component contact (46), the bonding wire (50) and the contact area (48) are sealed after the establishing of the bond connection and before the winding up.

8. A method in accordance with any one of the preceding claims, **characterized in that** components (10) are contacted on the circuit substrate (12) in parallel for a plurality of circuits (54) electrically separate from one another.

9. An apparatus for contacting at least one electrical component (10) on a flexible circuit substrate (12) comprising
an unwinding unit (14) by means of which a circuit substrate (12) wound up as a roll can be held and unwound;
a positioning device (16) for the positioning of the electrical component (10) on the circuit substrate (12);
a connection device (18) for the establishing of a wire bond connection between at least one component contact (46) of the component (10) and at least one contact area (48) on the flexible circuit substrate (12);
a winding up unit (22) for the winding up of at least parts of the flexible circuit substrate (12) as a roll; and
a conveying device (42) by means of which the circuit substrate (12) is continuously movable,
**characterized in that**
the connection device (18) is made such that a tool (36) for the establishment of the wire bond connection can be moved along with the circuit substrate (12) on the establishing of the wire bond connection.

10. An apparatus in accordance with claim 9, **characterized in that** at least one vacuum table (28, 34) is provided onto which the circuit substrate (12) can be pulled by underpressure on the positioning of the component (10) and/or on the establishment of the wire bond connection.

11. An apparatus in accordance with claim 9 or claim 10, **characterized in that** a stamping device (52) is provided before the winding up unit (22) to stamp out a region (54) of a section (24) of the flexible circuit substrate (12) with the component (10).

12. An apparatus in accordance with any one of claims 9 to 11, **characterized in that** a sealing device (20) is arranged after the connection device (18) in the transport direction of the flexible circuit substrate (12), by means of which at least the component contact (46), the bonding wire (50) and the contact area (48) can be sealed after the establishment of the bond connection and before the winding up.

## Revendications

1. Procédé pour la réalisation de contacts sur au moins un composant électrique (10) sur un porte-circuits flexible (12), dans lequel le porte-circuits flexible (12) à oeuvrer est enroulé sous forme de bobine,
pour la réalisation du contact, on déroule un tronçon (24) du porte-circuits flexible (12) depuis la bobine,
le composant (10) est agencé sur le tronçon (24) du porte-circuits flexible (12),
entre au moins un contact (46) du composant (10) et au moins une surface de contact (48) sur le porte-circuits flexible (12) on établit une jonction brasée à fil, et
au moins une partie du tronçon (24) du porte-circuits (12) est à nouveau enroulée en bobine,
**caractérisé en ce que**
le porte-circuits (12) est déroulé en continu et un outil (36) pour réaliser la jonction brasée à fil est déplacé conjointement avec le porte-circuits (12) pendant l'établissement de la liaison brasée.

2. Procédé selon la revendication 1, **caractérisé en ce que** l'on utilise un procédé de liaison aux ultrasons pour établir la jonction brasée.

3. Procédé selon la revendication 1 ou 2, **caractérisé en ce que** l'on établit une jonction brasée du type à bille-et-coin.

4. Procédé selon l'une des revendications précédentes, **caractérisé en ce que** le tronçon (24) du porte-circuits flexible (12) est tiré par dépression sur une surface de travail (28, 34) pour l'agencement du composant (10) sur lui-même et/ou pour l'établissement de la jonction brasée.

5. Procédé selon l'une des revendications précédentes, **caractérisé en ce que** le tronçon (24) du porte-circuits flexible (12) est enroulé sous forme de bobine avec le composant (10).

6. Procédé selon l'une des revendications 1 à 4, **caractérisé en ce qu'**une zone (54) du tronçon (24) du porte-circuits flexible (12) avec le composant électrique (10) est poinçonnée, et **en ce que** la zone non poinçonnée du tronçon (24) du porte-circuits flexible (12) est enroulée sous forme de bobine.

7. Procédé selon l'une des revendications précédentes, **caractérisé en ce que**, après établissement de la jonction brasée et avant l'enroulement, au moins le contact (46) du composant, le fil de jonction (50) et la surface de contact (48) sont revêtus d'un vernis.

8. Procédé selon l'une des revendications précédentes, **caractérisé en ce que** l'on réalise des contacts sur des composants (10) sur le porte-circuits (12) parallèlement pour plusieurs circuits (54) électriquement séparés les uns des autres.

9. Appareil pour la réalisation de contacts sur au moins un composant électrique (10) sur un porte-circuits flexible (12), comprenant :
une unité de déroulement (14), au moyen de laquelle un porte-circuits (12) est enroulé sous forme de bobine peut être maintenu et déroulé,
un dispositif de positionnement (16) pour positionner le composant électrique (10) sur le porte-circuits (12),
un dispositif de jonction (18) pour établir une jonction brasée à fil entre au moins un contact (46) du composant (10) et au moins une surface de contact (48) sur le porte-circuits flexible (12),
une unité d'enroulement (22) pour enrouler au moins certaines parties du porte-circuits flexible (12) sous forme de bobine, et
un dispositif de convoyage (22) au moyen duquel le porte-circuits (12) peut être déplacé en continu,
**caractérisé en ce que**
le dispositif de jonction (18) est ainsi réalisé qu'un outil (36) pour la réalisation de la jonction brasée est déplacé conjointement avec le porte-circuits (12) pendant l'établissement de la jonction brasée.

10. Appareil selon la revendication 9, **caractérisé en ce qu'**il est prévu au moins une table à vide (28, 34) sur laquelle le porte-circuits (12) peut être tiré par dépression lors du positionnement du composant (10) et/ou de l'établissement de la jonction brasée.

11. Appareil selon la revendication 9 ou 10, **caractérisé en ce qu'**il est prévu un dispositif de poinçonnage (52) devant l'unité d'enroulement (22), pour poinçonner une zone (54) d'un tronçon (24) du porte-circuits flexible (12) avec le composant (10).

12. Appareil selon l'une des revendications 9 à 11, **caractérisé en ce qu'**une unité d'application de vernis (20) est agencée après le dispositif de jonction (18) dans la direction de transport du porte-circuits flexible (12), au moyen de laquelle, après établissement de la jonction brasée et avant enroulement, au moins le contact (46) du composant, le fil de jonction (50) et la surface de contact (48) peuvent être recouverts de vernis.
